# EUROPEAN PATENT SPECIFICATION

(11) **EP 4 492 761 B1**
(45) Date of publication and mention of the grant of the patent: **21.01.2026**
(21) Application number: 24706352.2
(22) Date of filing: 21.02.2024
(51) Int. Cl.: H04M 1/02, H04M 1/03, G06F 1/16

(54) **ELECTRONIC DEVICE COMPRISING STRUCTURE FOR REDUCING INFLOW OF FOREIGN SUBSTANCES**
ELEKTRONISCHE VORRICHTUNG MIT STRUKTUR ZUR REDUZIERUNG DES EINFLUSSES VON FREMDSTOFFEN
DISPOSITIF ÉLECTRONIQUE COMPRENANT UNE STRUCTURE POUR RÉDUIRE L'ENTRÉE DE SUBSTANCES ÉTRANGÈRES

(30) Priority: 01.06.2023 KR 20230071135; 19.06.2023 KR 20230078054
(43) Date of publication of application: 15.01.2025
(73) Proprietor: Samsung Electronics Co., Ltd., Suwon-si, Gyeonggi-do 16677 (KR)
(72) Inventor: BAEK, Moohyun, Suwon-si Gyeonggi-do 16677 (KR); KIM, Gidae, Suwon-si Gyeonggi-do 16677 (KR); MOCK, Jina, Suwon-si Gyeonggi-do 16677 (KR); JUNG, Soli, Suwon-si Gyeonggi-do 16677 (KR)
(74) Representative: Gulde & Partner
(86) International application number: PCT/KR2024/002223
(87) International publication number: WO 2024/248272

(56) References cited:
- CN-U- 212 413 241
- KR-A- 20150 105 143
- KR-A- 20210 105 782
- KR-B1- 101 516 766
- US-B2- 9 444 506

## Description

### [Technical Field]

The present disclosure relates to an electronic device including a structure for reducing the inflow of foreign substances.

### [Background Art]

An electronic device may include electronic components capable of implementing various functions in response to a user's request. As the user carries the electronic device, the electronic device may be exposed to various environments. The electronic device may include structures for securing the performance of electronic components so as to provide designed functions to the user in various environments. For example, the electronic device may include a structure for reducing the inflow of foreign substances into the electronic device.

Conventional electronic devices including a structure for reducing the inflow of foreign substances into the electronic device are disclosed in KR 2015 0105143 A.

### [Disclosure]

### [Technical Solution]

The invention is defined by the appended set of claims. The description that follows is subjected to this limitation. Any disclosure lying outside the scope of said claims is only intended for illustrative as well as comparative purposes.

An electronic device is provided according to claim 1.

### [Description of the Drawings]

FIG. 1 is a block diagram of an electronic device in a network environment according to various embodiments.
FIG. 2 is a diagram illustrating an exemplary electronic device according to an embodiment.
FIG. 3 is an exploded perspective view of an exemplary electronic device according to an embodiment.
FIG. 4A is a top view of an exemplary electronic device according to an embodiment.
FIG. 4B is an exploded perspective view of an exemplary electronic device according to an embodiment.
FIG. 5 is a cross-sectional view illustrating an example of an exemplary electronic device cut along line A-A' of FIG. 4A, according to an embodiment.
FIG. 6A is a top view of an exemplary support plate according to an embodiment.
FIG. 6B is a cross-sectional view illustrating an example of an exemplary support plate cut along line B-B' of FIG. 6A, according to an embodiment.
FIG. 6C is a cross-sectional view illustrating an example of an exemplary cut support plate according to an embodiment.
FIG. 7A is a rear view of an electronic device according to an embodiment.
FIG. 7B illustrates a state in which a support plate is coupled to an exemplary frame according to an embodiment.
FIG. 7C is a cross-sectional view illustrating an example of an exemplary electronic device cut along line C-C' of FIG. 7A, according to an embodiment.
FIGS. 8A to 8E illustrate an example of a method of manufacturing an electronic device according to an embodiment.
FIG. 9A illustrates an exemplary cover plate according to an embodiment.
FIG. 9B is a cross-sectional view illustrating an example of a cut electronic device according to an embodiment.

### [Mode for Invention]

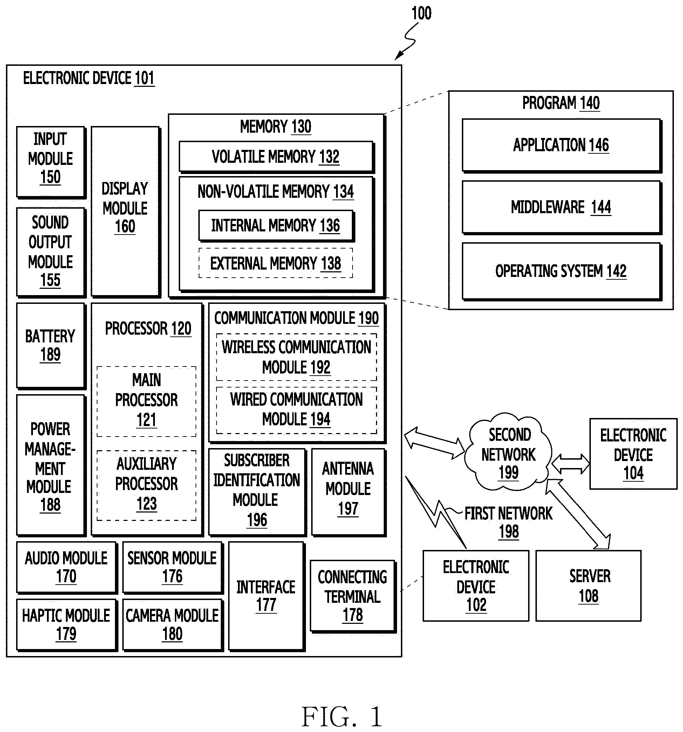

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

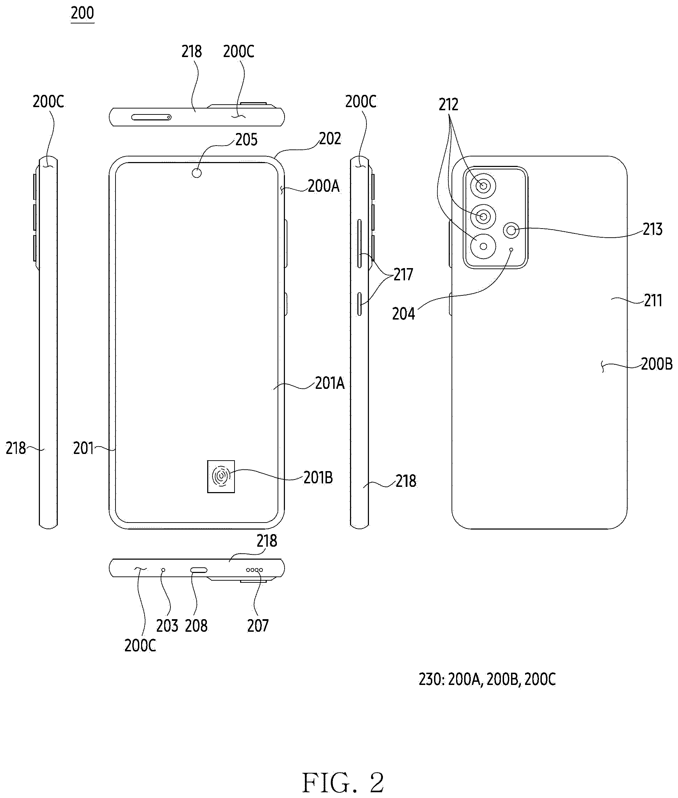

FIG. 2 is a diagram illustrating an exemplary electronic device according to an embodiment.

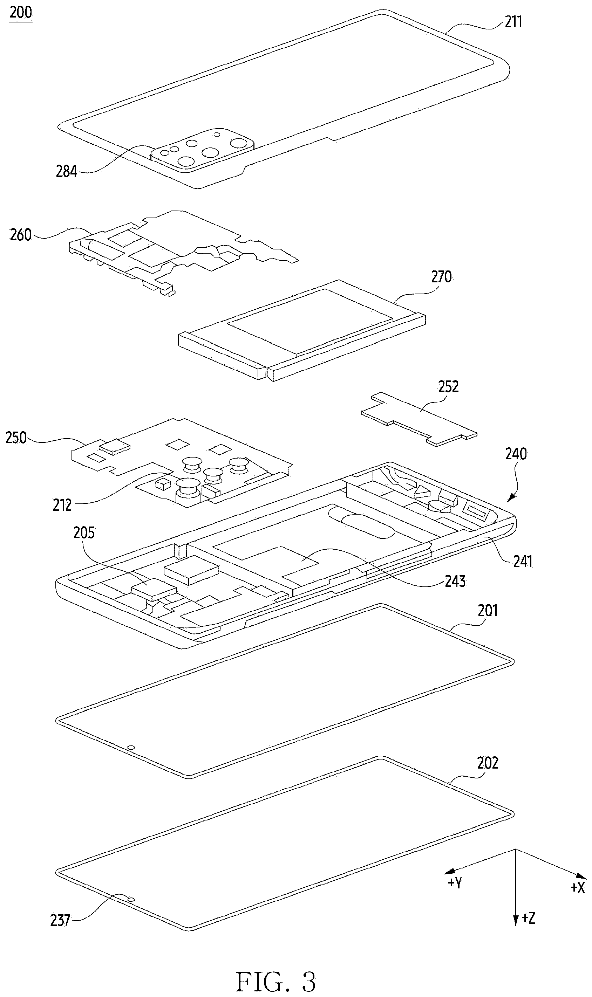

Referring to FIG. 2, according to an embodiment, an electronic device 200 (e.g., the electronic device 101 of FIG. 1) may include a housing 230 forming the exterior of the electronic device 200. For example, the housing 230 may include a first surface (or front surface) 200A, a second surface (or rear surface) 200B, and a third surface (or side surface) 200C surrounding a space between the first surface 200A and the second surface 200B. In an example, the housing 230 may refer to a structure (e.g., a frame 240 of FIG. 3) forming at least a part of the first surface 200A, the second surface 200B, and/or the third surface 200C.

According to an embodiment, the electronic device 200 may include a substantially transparent front plate 202. In an embodiment, the front plate 202 may form at least a part of the first surface 200A. In an embodiment, the front plate 202 may include, for example, a glass plate or a polymer plate including various coating layers, but is not limited thereto.

According to an embodiment, the electronic device 200 may include a substantially opaque rear plate 211. In an embodiment, the rear plate 211 may form at least a part of the second surface 200B. In an embodiment, the rear plate 211 may be formed by coating or coloring glass, ceramic, polymer, metal (e.g., aluminum, stainless steel (STS), or magnesium), or a combination of at least two of the above materials.

According to an embodiment, the electronic device 200 may include a side bezel structure (or a side surface member) 218 (e.g., a sidewall 241 of a frame 240 of FIG. 3). In an embodiment, the side bezel structure 218 may be coupled to the front plate 202 and/or the rear plate 211 to form at least a part of the third surface 200C of the electronic device 200. For example, the side bezel structure 218 may form the entire third surface 200C of the electronic device 200, and in an embodiment, the side bezel structure 218 may form the third surface 200C of the electronic device 200 together with the front plate 202 and/or the rear plate 211.

In an embodiment (not shown), when the third surface 200C of the electronic device 200 is partially formed by the front plate 202 and/or the rear plate 211, the front plate 202 and/or the rear plate 211 may include an area, which is bent from an edge toward the rear plate 211 and/or the front plate 202 and extends seamlessly. For example, the extended area of the front plate 202 and/or the rear plate 211 may be located at both ends of a long edge of the electronic device 200, but is not limited to the above-described example.

In an embodiment, the side bezel structure 218 may include metal and/or polymer. In an embodiment, the rear plate 211 and the side bezel structure 218 may be integrally formed, and may include the same material (e.g., a metal material such as aluminum), but are not limited thereto. For example, the rear plate 211 and the side bezel structure 218 may be formed in a separate configuration and/or may include different materials.

According to an embodiment, the electronic device 200 may include at least one of the display 201, audio modules 203, 204, and 207, a sensor module (not shown), a camera module 205, 212, and 213, a key input device 217, a light emitting device (not shown), and/or a connector hole 208. In an embodiment, the electronic device 200 may omit at least one of the components (e.g., the key input device 217 or the light emitting device (not shown)), or may additionally include another component.

In an embodiment, the display 201 (e.g., the display module 160 of FIG. 1) may be visually exposed through a significant portion of the front plate 202. For example, at least a part of the display 201 may be viewed through the front plate 202 forming the first surface 200A. In an embodiment, the display 201 may be disposed on a back of the front plate 202.

In an embodiment, an exterior shape of the display 201 may be formed substantially the same as an exterior shape of the front plate 202 adjacent to the display 201. In an embodiment, in order to expand an area in which the display 201 is visually exposed, an interval between an exterior of the display 201 and an exterior of the front plate 202 may be formed substantially the same.

In an embodiment, the display 201 (or the first surface 200A of the electronic device 200) may include a screen display area 201A. In an embodiment, the display 201 may provide visual information to a user through the screen display area 201A. In the illustrated embodiment, when the first surface 200A is viewed in front, it is illustrated that the screen display area 201A is spaced apart from an exterior of the first surface 200A and located inside the first surface 200A, but it is not limited thereto. In an embodiment, when the first surface 200A is viewed in front, at least a part of an edge of the screen display area 201A may substantially match an edge of the first surface 200A (or the front plate 202).

In an embodiment, the screen display area 201A may include a sensing area 201B configured to obtain biometric information of a user. Herein, the meaning of "the screen display area 201A includes the sensing area 201B" may be understood as at least a part of the sensing area 201B is overlapped on the screen display area 201A. For example, the sensing area 201B may refer to an area capable of displaying visual information by the display 201 and obtaining the user's biometric information (e.g., fingerprint), like as another area of the screen display area 201A. In an embodiment, the sensing area 201B may be formed in the key input device 217.

According to an embodiment, the display 201 may include an area in which the first camera module 205 (e.g., the camera module 180 of FIG. 1) is located. In an embodiment, an opening is formed in the area of the display 201, and the first camera module 205 (e.g., a punch hole camera) may be disposed at least partially within the opening to face the first surface 200A. For example, the screen display area 201A may surround at least a part of a periphery of the opening. In an embodiment, the first camera module 205 (e.g., an under display camera (UDC)) may be disposed under the display 201 in order to overlapped with the area of the display 201. For example, the display 201 may provide visual information to the user through the area, and additionally, the first camera module 205 may obtain an image corresponding to a direction toward the first surface 200A through the area of the display 201.

In an embodiment, the display 201 may be coupled with or disposed adjacent to a touch detection circuit, a pressure sensor capable of measuring the intensity (pressure) of touch, and/or a digitizer detecting a magnetic field-type stylus pen.

In an embodiment, an audio module 203, 204, and 207 (e.g., the audio module 170 of FIG. 1) may include a microphone hole 203 and 204 and a speaker hole 207.

In an embodiment, the microphone hole 203 and 204 may include a first microphone hole 203 formed in a partial area of the third surface 200C and a second microphone hole 204 formed in a partial area of the second surface 200B. A microphone (not shown) for obtaining an external sound may be disposed inside the microphone hole 203 and 204. The microphone may include a plurality of microphones to detect a direction of sound.

In an embodiment, the second microphone hole 204 formed in a partial area of the second surface 200B may be disposed adjacent to the camera module 205, 212, and 213. For example, the second microphone hole 204 may obtain sound according to an operation of the camera module 205, 212, and 213. However, it is not limited thereto.

In an embodiment, the speaker hole 207 may include an external speaker hole 207 and a receiver hole for a call (not shown). The external speaker hole 207 may be formed in a portion of the third surface 200C of the electronic device 200. According to an embodiment, the external speaker hole 207 and the microphone hole 203 may be implemented as a single hole. Although not shown, the receiver hole for a call (not shown) may be formed on another portion of the third surface 200C. For example, the receiver hole for a call may be formed on the opposite side of the external speaker hole 207, in the third surface 200C. For example, based on the illustration of FIG. 2, the external speaker hole 207 may be formed on the third surface 200C corresponding to a lower end of the electronic device 200, and the receiver hole for a call may be formed on the third surface 200C corresponding to an upper end of the electronic device 200. However, it is not limited thereto, and in an embodiment, the receiver hole for a call may be formed at a position other than the third surface 200C. For example, the receiver hole for a call may be formed by a spaced space between the front plate 202 (or the display 201) and the side bezel structure 218.

In an embodiment, the electronic device 200 may include at least one speaker (not shown) configured to output sound to the outside of the housing 230 through the external speaker hole 207 and/or the receiver hole for a call (not shown).

In an embodiment, the sensor module (not shown) (e.g., the sensor module 176 of FIG. 1) may generate an electrical signal or data value corresponding to an internal operating state of the electronic device 200 or an external environmental state. For example, the sensor module may include at least one of a proximity sensor, an HRM sensor, a fingerprint sensor, a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera module 205, 212, and 213 (e.g., the camera module 180 of FIG. 1) may include a first camera module 205 disposed to face the first surface 200A of the electronic device 200, a second camera module 212 disposed to face the second surface 200B, and a flash 213.

In an embodiment, the second camera module 212 may include a plurality of cameras (e.g., dual camera, triple camera, or quad camera). However, the second camera module 212 is not necessarily limited to including a plurality of cameras, and may include one camera.

In an embodiment, the first camera module 205 and the second camera module 212 may include one or more lenses, an image sensor, and/or an image signal processor.

In an embodiment, the flash 213 may include, for example, a light emitting diode or a xenon lamp. In an embodiment, two or more lenses (infrared camera, wide-angle and telephoto lens) and image sensors may be disposed on a surface of the electronic device 200.

In an embodiment, the key input device 217 (e.g., the input module 150 of FIG. 1) may be disposed on the third surface 200C of the electronic device 200. In an embodiment, the electronic device 200 may not include some or all of the key input devices 217, and the key input device 217, which is excluded, may be implemented on the display 201 in another form, such as a soft key.

In an embodiment, the connector hole 208 may be formed on the third surface 200C of the electronic device 200 so that a connector of an external device may be accommodated. A connecting terminal (e.g., the connecting terminal 178 of FIG. 1) electrically connected to the connector of the external device may be disposed within the connector hole 208. According to an embodiment, the electronic device 200 may include an interface module (e.g., the interface 177 of FIG. 1) for processing an electrical signal transmitted and received through the connecting terminal.

According to an embodiment, the electronic device 200 may include a light emitting device (not shown). For example, the light emitting device (not shown) may be disposed on the first surface 200A of the housing 230. The light emitting device (not shown) may provide state information of the electronic device 200 in an optical form. In an embodiment, the light emitting device (not shown) may provide a light source linked with an operation of the first camera module 205. For example, the light emitting device (not shown) may include an LED, an IR LED, and/or a xenon lamp.

FIG. 3 is an exploded perspective view of an exemplary electronic device according to an embodiment.

Hereinafter, a redundant description of a configuration having the same reference numerals as the above-described configuration will be omitted.

Referring to FIG. 3, according to an embodiment, the electronic device 200 may include a frame 240, a first printed circuit board 250, a second printed circuit board 252, a coupling member 260, and a battery 270.

In an embodiment, the frame 240 may include a sidewall 241 forming the exterior of the electronic device 200 (e.g., the third surface 200C of FIG. 2) and a support part 243 extending inward from the sidewall 241. In an embodiment, the frame 240 may be disposed between a display 201 and a rear plate 211. In an embodiment, the sidewall 241 of the frame 240 may surround a space between the rear plate 211 and a front plate 202 (and/or the display 201), and the support part 243 of the frame 240 may extend from the sidewall 241 within the space.

According to an embodiment, the frame 240 may support or accommodate other components included in the electronic device 200. For example, the display 201 may be disposed on a surface of the frame 240 facing a direction (e.g., +z direction), and the display 201 may be supported by the support part 243 of the frame 240. In an embodiment, the first printed circuit board 250, the second printed circuit board 252, the battery 270, and a second camera module 212 may be disposed on another surface of the frame 240 facing a direction (e.g., -z direction) opposite to the direction. The first printed circuit board 250, the second printed circuit board 252, the battery 270, and the second camera module 212 may be respectively seated in a recess defined by the sidewall 241 and/or the support part 243 of the frame 240.

In an embodiment, the first printed circuit board 250, the second printed circuit board 252, and the battery 270 may be coupled to the frame 240, respectively. For example, the first printed circuit board 250 and the second printed circuit board 252 may be fixedly disposed on the frame 240 through a coupling member such as a screw. For example, the battery 270 may be fixedly disposed on the frame 240 through an adhesive member (e.g., double-sided tape). However, it is not limited to the above-described example.

In an embodiment, the coupling member 260 may be disposed between the first printed circuit board 250 and the rear plate 211. In an embodiment, the coupling member 260 may be disposed on the first printed circuit board 250. For example, the coupling member 260 may be disposed on a surface of the first printed circuit board 250 facing the -z direction.

In an embodiment, the coupling member 260 may at least partially overlapped with the first printed circuit board 250 with respect to the z-axis. In an embodiment, the coupling member 260 may cover at least a part of the first printed circuit board 250. Through this, the coupling member 260 may protect the first printed circuit board 250 from physical impact or prevent or reduce separation of the connector coupled to the first printed circuit board 250.

In one example, the coupling member 260 may be fixedly disposed on the first printed circuit board 250 through a fastening member (e.g., a screw), or coupled to the frame 240 together with the first printed circuit board 250 through the fastening member.

In an embodiment, the display 201 may be disposed between the frame 240 and the front plate 202. For example, the front plate 202 may be disposed on a side (e.g., +z direction) of the display 201, and the frame 240 may be disposed on another side (e.g., -z direction).

In an embodiment, the front plate 202 may be coupled to the display 201. For example, the front plate 202 and the display 201 may be bonded to each other through optical adhesive members (e.g., optically clear adhesive (OCA) or optically clear resin (OCR) interposed therebetween.

In an embodiment, the front plate 202 may be coupled to the frame 240. For example, the front plate 202 may include an outer part extending outside the display 201 when viewed in the z-axis direction, and may be adhered to the frame 240 through an adhesive member (e.g., double-sided tape) disposed between the outer part of the front plate 202 and the frame 240 (e.g., the sidewall 241). However, it is not limited thereto.

In an embodiment, a processor (e.g., the processor 120 of FIG. 1), a memory (e.g., the memory 130 of FIG. 1), and/or an interface (e.g., the interface 177 of FIG. 1) may be mounted on the first printed circuit board 250 and/or the second printed circuit board 252. The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 200 with an external electronic device, and may include a USB connector, an SD card/MMC connector, or an audio connector. In an embodiment, the first printed circuit board 250 and the second printed circuit board 252 may be operably or electrically connected to each other via a connecting member (e.g., a flexible printed circuit board).

In an embodiment, the battery 270 (e.g., the battery 189 of FIG. 1) may supply power to at least one component of the electronic device 200. For example, the battery 270 may include a rechargeable secondary battery or a fuel cell. At least a part of the battery 270 may be disposed on substantially the same plane as the first printed circuit board 250 and/or the second printed circuit board 252.

According to an embodiment, the electronic device 200 may include an antenna module (not shown) (e.g., the antenna module 197 of FIG. 1). In an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with the external device.

In an embodiment, the first camera module 205 (e.g., the front camera) may be disposed on at least a part (e.g., the support part 243) of the frame 240 so that lens may receive external light through a partial area (e.g., the camera area 237) of the front plate 202 (e.g., the front surface 200A of FIG. 2).

In an embodiment, the second camera module 212 (e.g., the rear camera) may be disposed between the frame 240 and the rear plate 211. In an embodiment, the second camera module 212 may be electrically connected to the first printed circuit board 250 through a connecting member (e.g., a connector). In an embodiment, the second camera module 212 may be disposed so that the lens may receive external light through the camera area 284 of the rear plate 211 of the electronic device 200.

In an embodiment, the camera area 284 may be formed on a surface (e.g., the rear surface 200B of FIG. 2) of the rear plate 211. In an embodiment, the camera area 284 may be formed at least partially transparent so that external light may be incident on the lens of the second camera module 212. In an embodiment, at least a part of the camera area 284 may protrude from the surface of the rear plate 211 to a predetermined height. However, it is not limited thereto, and in an embodiment, the camera area 284 may form substantially the same plane as a surface of the rear plate 211.

In an embodiment, a housing (e.g., the housing 230 of FIG. 2) of the electronic device 200 may refer to a configuration or structure forming at least a part of the exterior of the electronic device 200.

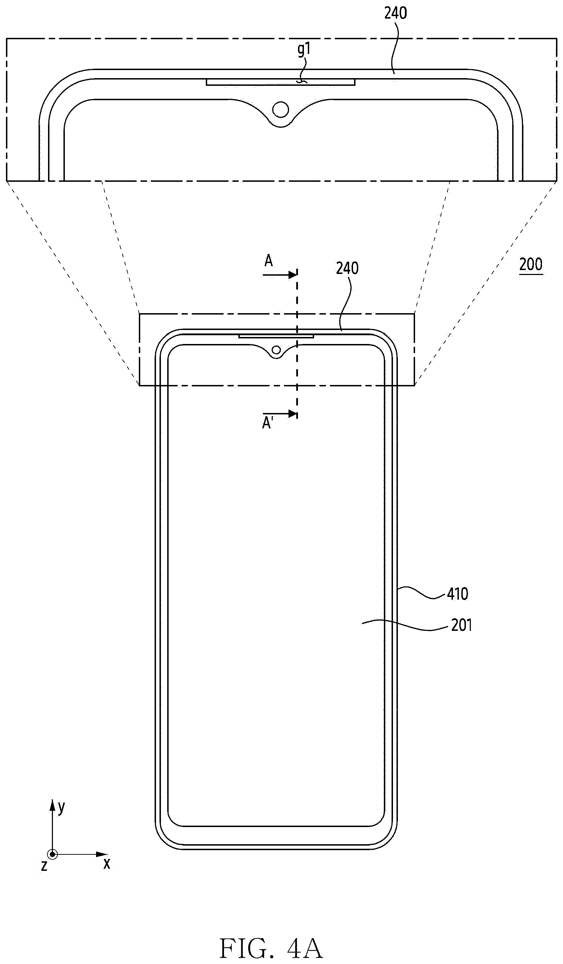

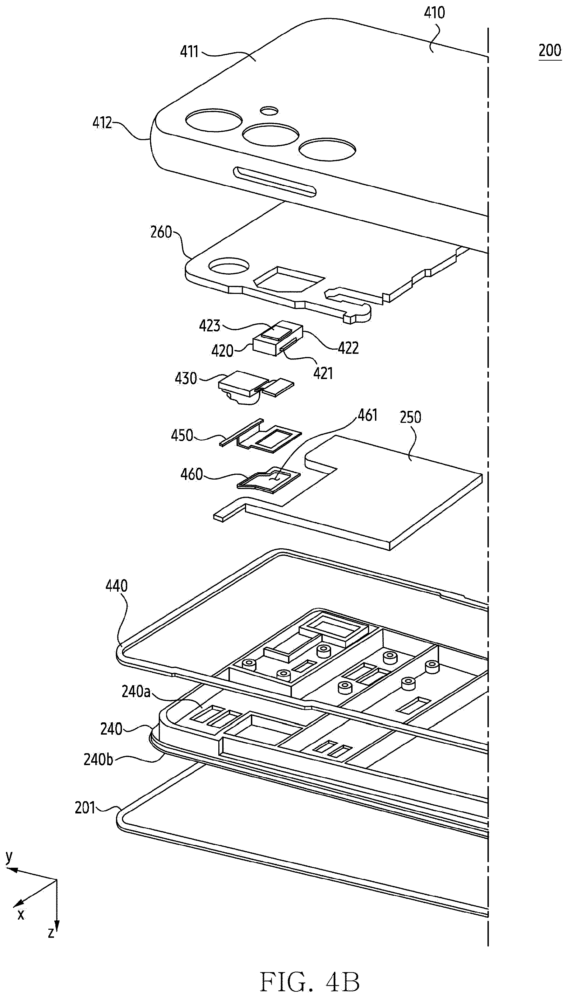

FIG. 4A is a top view of an exemplary electronic device according to an embodiment, and FIG. 4B is an exploded perspective view of an exemplary electronic device according to an embodiment.

Referring to FIGS. 4A and 4B, the electronic device 200 includes a frame 240, a cover plate 410, a first electronic component 420 (e.g., the sound output module 155 of FIG. 1), a waterproof member 440, and a support plate 450. Further, according to an embodiment, the electronic device 200 may include a display 201, a first printed circuit board 250, a coupling member 260, a second electronic component 430 (e.g., the camera module 180 of FIG. 1 and/or the first camera module 205 of FIG. 2), and/or an adhesive member 460.

According to an embodiment, the frame 240 may support components of the electronic device 200. The frame 240 may form (or define) a space in which components of the electronic device 200 may be disposed. For example, the first printed circuit board 250, the coupling member 260, the first electronic component 420, and/or the second electronic component 430 may be disposed on a surface 240a of the frame 240. For example, the display 201 may be disposed on another surface 240b of the frame 240. The other surface 240b of the frame 240 may be opposite to the surface 240a of the frame 240. For example, a direction (e.g., a +z direction) in which the other surface 240b of the frame 240 faces may be opposite to a direction (e.g., a -z direction) in which the surface 240a of the frame 240 faces.

According to an embodiment, the display 201 may be configured to provide visual information. The display 201 may be disposed on the frame 240. For example, the other surface 240b of the frame 240 may support the display 201. Since the other surface 240b of the frame 240 supports the display 201, it may be referred to as a support surface. The display 201 may form (or define) at least a part of a front surface of the electronic device 200. For example, the front surface of the electronic device 200 may face a user while the user of the electronic device 200 is provided with visual information through the display 201.

According to an embodiment, the first printed circuit board 250 may form (or establish) an electrical connection between electronic components in the electronic device 200. For example, the first printed circuit board 250 may be electrically connected to the first electronic component 420 and/or the second electronic component 430. For example, the first printed circuit board 250 may include a processor (e.g., the processor 120 of FIG. 1) disposed (attached) on the first printed circuit board 250. The processor 120 may control an operation of at least one of the first electronic component 420 and the second electronic component 430. When the first printed circuit board 250 includes the processor 120, the first printed circuit board 250 may be referred to as a main printed circuit board. According to an embodiment, the first printed circuit board 250 may be disposed on the frame 240. Since various components of the electronic device 200 are attached, the surface 240a of the frame 240 may be referred to as an attachment surface.

According to an embodiment, the coupling member 260 may support components in the electronic device 200. The coupling member 260 may maintain positions of components in the electronic device 200. For example, the coupling member 260 may support the first electronic component 420, the second electronic component 430, and/or the support plate 450. The coupling member 260 may be disposed on the surface 240a of the frame 240. At least a part of the coupling member 260 may be disposed between the first printed circuit board 250 and the cover plate 410. For example, the coupling member 260 may be wrapped (or surrounded) by the cover plate 410.

According to an embodiment, the cover plate 410 may define at least a part of an outer surface of the electronic device 200. For example, the cover plate 410 may define (or form) a rear surface of the electronic device 200. The rear surface of the electronic device 200 may be opposite to the front surface of the electronic device 200. For example, a direction (e.g., -z direction) in which the rear surface of the electronic device 200 faces may be opposite to a direction (e.g., +z direction) in which the front surface of the electronic device 200 faces. The cover plate 410 may define (or form) an outer side surface of the electronic device 200. The outer side surface of the electronic device 200 may connect the front surface of the electronic device 200 and the rear surface of the electronic device 200. The outer side surface of the electronic device 200 may be disposed between the front surface of the electronic device 200 and the rear surface of the electronic device 200. For example, the outer side surface of the electronic device 200 may be substantially perpendicular with respect to the front surface of the electronic device 200, but is not limited thereto. For example, the outer side surface of the electronic device 200 may be bent to have a curvature. According to an embodiment, the cover plate 410 may protect components in the electronic device 200 disposed on the frame 240. The cover plate 410 may at least partially surround (or wrap) the frame 240. For example, the cover plate 410 may at least partially surround (or wrap) the first printed circuit board 250, the coupling member 260, the first electronic component 420, the second electronic component 430, and/or the support plate 450.

The cover plate 410 includes a first cover part 411 and a second cover part 412. The first cover part 411 may define (or form) the rear surface of the electronic device 200. The first cover part 411 may be substantially parallel to the surface 240a of the frame 240. For example, the surface 240a of the frame 240 faces and is spaced apart from the first cover part 411. The second cover part 412 may define (or form) an outer side surface of the electronic device 200. The second cover part 412 may be connected to the first cover part 411. The second cover part 412 may extend from an edge of the first cover part 411, in order to surround the frame 240. The second cover part 412 may wrap (or surround) the frame 240. The second cover part 412 may be bent with respect to the first cover part 411. For example, the second cover part 412 may be substantially perpendicular with respect to the first cover part 411, but is not limited thereto. For example, the second cover part 412 may be bent to have a curvature with respect to the first cover part 411.

According to an embodiment, the first electronic component 420 may be disposed in the frame 240. For example, the first electronic component 420 may be disposed on the surface 240a of the frame 240. For example, the first electronic component 420 may be disposed inside a recess formed (or defined) on the surface 240a of the frame 240. For example, the first electronic component 420 may be disposed between the frame 240 and the cover plate 410. For example, the first electronic component 420 may be disposed between the frame 240 and the coupling member 260.

According to an embodiment, the first electronic component 420 may implement a function to be provided to a user. For example, the first electronic component 420 may output audio for providing auditory information. For example, the first electronic component 420 may include a receiver configured to output a voice signal on a call connection from another electronic device distinct from the electronic device 200, but is not limited thereto. For example, the first electronic component 420 may include a speaker outputting audio. According to an embodiment, the first electronic component 420 may include a first surface 421, a second surface 422, and/or at least one side surface 423. The first surface 421 of the first electronic component 420 may face the surface 240a of the frame 240. The first surface 421 of the first electronic component 420 may be disposed on the surface 240a of the frame 240. For example, the first surface 421 of the first electronic component 420 may be attached to the surface 240a of the frame 240. For example, a direction (e.g., the +z direction) in which the first surface 421 of the first electronic component 420 faces may be opposite to a direction (e.g., the -z direction) in which the surface 240a of the frame 240 faces. The first electronic component 420 may output audio through the first surface 421 of the first electronic component 420. Audio from the first electronic component 420 outputted through the first surface 421 of the first electronic component 420 may be transmitted to the outside of the electronic device 200, through an audio gap g1 between the display 201 and the frame 240. The audio gap g1 may be disposed (or located) between the display 201 and the frame 240, and/or between the display 201 and the cover plate 410. The second surface 422 of the first electronic component 420 may be opposite to the first surface 421 of the first electronic component 420. A direction (e.g., -z direction) in which the second surface 422 of the first electronic component 420 faces may be opposite to a direction (e.g., +z direction) in which the first surface 421 of the first electronic component 420 faces. The second surface 422 of the first electronic component 420 may face the coupling member 260. The second surface 422 of the first electronic component 420 may face the first cover part 411 of the cover plate 410. The second surface 422 of the first electronic component 420 may be spaced apart from the first surface 421 of the first electronic component 420. At least one side surface 423 of the first electronic component 420 may connect the first surface 421 of the first electronic component 420 and the second surface 422 of the first electronic component 420. The side surface 423 may be disposed between the first surface 421 of the first electronic component 420 and the second surface 422 of the first electronic component 420. For example, the side surface 423 may extend from the first surface 421 of the first electronic component 420 to the second surface 422 of the first electronic component 420.

According to an embodiment, the second electronic component 430 may be disposed in the frame 240. For example, the second electronic component 430 may be disposed on the surface 240a of the frame 240. The second electronic component 430 may be disposed inside a recess formed (or defined) on the surface 240a of the frame 240. For example, the second electronic component 430 may be disposed between the frame 240 and the cover plate 410. For example, the second electronic component 430 may be disposed between the frame 240 and the coupling member 260. According to an embodiment, the second electronic component 430 may be directed in a direction (e.g., +z direction) in which the first surface 421 of the first electronic component 420 faces. The second electronic component 430 may include an image sensor for obtaining an image based on receiving light from an object external to the electronic device 200. The second electronic component 430 may be referred to as at least one of a camera or a camera module.

According to an embodiment, the waterproof member 440 may reduce the inflow of foreign substances (e.g., dust or moisture) into the electronic device 200. The waterproof member 440 may fill a gap between the frame 240 and the cover plate 410. The waterproof member 440 may be disposed along an edge of the frame 240. For example, the waterproof member 440 may form (or define) a closed loop by extending along the edge of the frame 240. For example, the waterproof member 440 may be disposed along an edge of the first cover part 411 of the cover plate 410. The waterproof member 440 may be contacted (or attached, or bonded) to the frame 240 and the cover plate 410. For example, the waterproof member 440 may include a sponge, silicone, rubber, and/or adhesive material (e.g., glue, double-sided tape). For example, the waterproof member 440 may include a waterproof sponge configured to correspond to identification code for protection 44 spec (IP44).

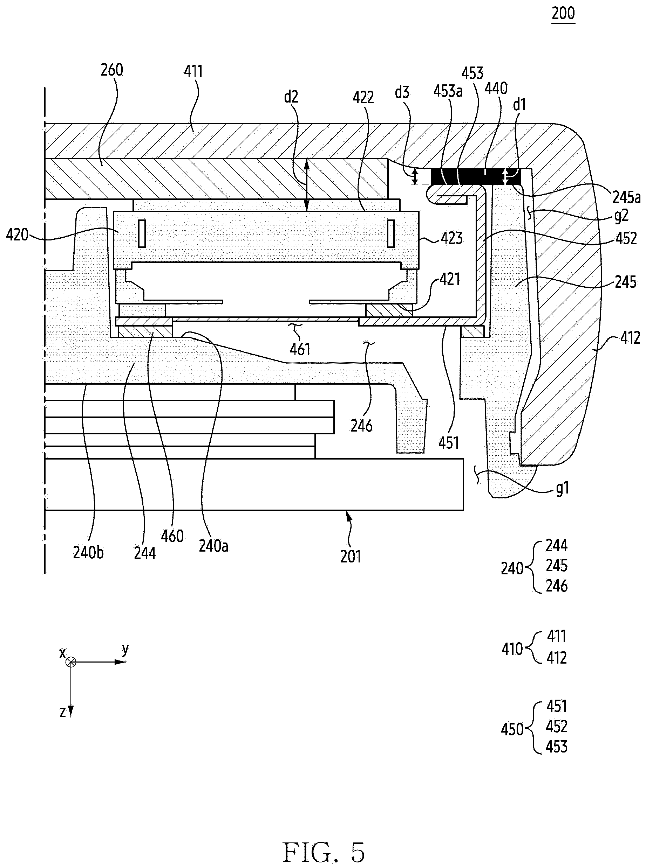

According to an embodiment, the support plate 450 may support the first electronic component 420. According to an embodiment, the support plate 450 may reinforce the rigidity of the first electronic component 420. For example, the support plate 450 may include a material (e.g., stainless steel (SS)) for rigidity of the first electronic component 420. The support plate 450 may secure an area to which the waterproof member 440 is attached. For example, the support plate 450 may be contacted (or attached) to the waterproof member 440. A relationship between the support plate 450 and the waterproof member 440 may be described with reference to FIG. 5.

According to an embodiment, the adhesive member 460 may attach the first electronic component 420 to the frame 240. For example, the adhesive member 460 may be disposed (or interposed) between the first electronic component 420 and the surface 240a of the frame 240. For example, the adhesive member 460 may include an adhesive material disposed on a surface of the adhesive member 460 facing the first electronic component 420 and another surface of the adhesive member 460 facing the surface 240a of the frame 24. The adhesive member 460 may be referred to as a double-sided tape. According to an embodiment, the adhesive member 460 may include a first opening 461. The first opening 461 may penetrate the adhesive member 460. The first opening 461 may provide a path through which audio from the first surface 421 of the first electronic component 420 may move to the outside of the frame 240.

FIG. 5 is a cross-sectional view illustrating an example of an exemplary electronic device cut along line A-A' of FIG. 4A, according to an embodiment.

Referring to FIG. 5, the cover plate 410 is coupled to the frame 240. The cover plate 410 may at least partially surround (or wrap) the first electronic component 420 and the frame 240. The first cover part 411 of the cover plate 410 may be spaced apart while facing the second surface 422 of the first electronic component 420. For example, the first cover part 411 of the cover plate 410 may be disposed on the second surface 422 of the first electronic component 420. For example, the first cover part 411 may have a shape substantially parallel to the second surface 422 of the first electronic component 420. The second cover part 412 may be spaced apart while facing at least one side surface 423 of the first electronic component 420. The second cover part 412 may be spaced apart from at least one side surface 423 of the first electronic component 420 and may at least partially wrap (or surround) the frame 240.

According to an embodiment, the frame 240 may at least partially wrap (or surround) the first electronic component 420. The frame 240 may include a seating part 244, a partition wall part 245, and/or an audio path 246. The seating part 244 may support the first electronic component 420. The first electronic component 420 may be disposed on the seating part 244. The first electronic component 420 may be attached (or contacted) to the seating part 244. The first surface 421 of the first electronic component 420 may be attached (or contacted) to the seating part 244. The seating part 244 may include (or define, or form) at least a part of the other surface 240b of the frame 240 and at least a part of the surface 240a of the frame 240. For example, the seating part 244 may represent a part of the frame 240 to which the first electronic component 420 is attached. The partition wall part 245 may at least partially wrap (or surround) the first electronic component 420. For example, the partition wall part 245 may face at least one side surface 423 of the first electronic component 420. The partition wall part 245 may surround at least one side surface 423 of the first electronic component 420. The partition wall part 245 may protrude from the seating part 244. For example, the partition wall part 245 may extend from the seating part 244 along the direction (e.g., -z direction) in which the second surface 422 of the first electronic component 420 faces. The partition wall part 245 may be spaced apart from the first electronic component 420. For example, the partition wall part 245 may be spaced apart from at least one side surface 423 of the first electronic component 420. The partition wall part 245 may be disposed between at least one side surface 423 of the first electronic component 420 and the second cover part 412. The partition wall part 245 may represent a part of the frame 240 protruding from the surface 240a of the frame 240, in order to wrap at least one side surface 423 of the first electronic component 420.

According to an embodiment, the audio path 246 may provide (or form) a path through which audio from the first surface 421 of the first electronic component 420 is transmitted to the outside of the electronic device 200. The audio path 246 may penetrate the surface 240a of the frame 240. For example, the audio path 246 may extend from the surface 240a of the frame 240 to the other surface 240b of the frame 240. The audio path 246 may be connected to the first opening 461. The audio from the first surface 421 of the first electronic component 420 may be transmitted to the audio gap g1 between the display 201 and the frame 240 by moving along the audio path 246. The audio from the first surface 421 of the first electronic component 420 may be transmitted to the outside of the electronic device 200 by passing through the audio gap g1.

According to an embodiment, the support plate 450 may include a first portion 451, a second portion 452, and/or a third portion 453.

According to an embodiment, the first portion 451 may reinforce rigidity of the first electronic component 420 to reduce damage to the first electronic component 420 in the frame 240. The first portion 451 may be disposed on the first surface 421 of the first electronic component 420. The first portion 451 may be attached (or contacted) to the first surface 421 of the first electronic component 420. For example, the first portion 451 may be substantially parallel to the first surface 421 of the first electronic component 420. For example, the first portion 451 may be attached on the first surface 421 of the first electronic component 420 through an adhesive material (not shown), but is not limited thereto. For example, the first portion 451 may be integrally formed with the first electronic component 420. The first portion 451 may be disposed (or interposed) between the first surface 421 of the first electronic component 420 and the seating part 244. The first portion 451 may be disposed on the seating part 244. The first portion 451 may be attached on the surface 240a of the frame 240. For example, the first portion 451 may be disposed on the seating part 244 through an adhesive member 460 disposed (or interposed) between the seating part 244 and the first portion 451. The adhesive member 460 may maintain a position of the first portion 451 in the frame 240, by being contacting (or attaching) to the first portion 451 and the seating part 444.

According to an embodiment, the second portion 452 may be connected to the first portion 451. The second portion 452 may extend from the first portion 451. The second portion 452 may extend from the first portion 451 toward the cover plate 410. The second portion 452 may extend from the first portion 451 toward the first cover part 411. The second portion 452 may extend along at least one side surface 423. The second portion 452 may be substantially perpendicular to the first portion 451, but is not limited thereto. The second portion 452 may be inclined with respect to the first portion 451. The second portion 452 may be disposed between at least one side surface 423 and the partition wall part 245. The second portion 452 may be faced away from at least one side surface 423.

According to an embodiment, the third portion 453 may be connected to the second portion 452. The third portion 453 may be spaced apart from the first portion 451. The second portion 452 may connect the first portion 451 and the third portion 453, which are spaced apart from each other. The third portion 453 may be bent with respect to the second portion 452. For example, the third portion 453 may be bent with respect to the second portion 452 to be parallel with respect to the first portion 451, but is not limited thereto. The third portion 453 may provide a space to which the waterproof member 440 may be attached. For example, the waterproof member 440 may be attached to a surface 453a of the third portion 453. The surface 453a of the third portion 453 may face in a direction (e.g., -z direction) in which the second surface 422 of the first electronic component 420 faces. The surface 453a of the third portion 453 may face the first cover part 411. The surface 453a of the third portion 453 may be substantially parallel to the first surface 421 of the first electronic component 420. For example, the surface 453a of the third portion 453 may be substantially parallel to the first portion 451. According to an embodiment, the third portion 453 may be bent with respect to the second portion 452 in a direction (e.g., -y direction) toward the inside of the frame 240. For example, the third portion 453 may be bent with respect to the second portion 452 in a direction (e.g., -y direction) faced away from the partition wall part 245, but is not limited thereto.

According to an embodiment, the waterproof member 440 may fill a gap g2 between the frame 240 and the cover plate 410. The gap g2 may have a shape extending between the frame 240 and the cover plate 410. For example, the gap g2 may extend between the partition wall part 245 and the second cover part 412, and between the partition wall part 245 and the first cover part 411. The waterproof member 440 may seal the frame 240 and the cover plate 410 in order to reduce the amount of foreign substances (e.g., dust or moisture) penetrating into the electronic device 200, by passing through the gap g2. The waterproof member 440 may be disposed (or interposed) between the third portion 453 and the first cover part 411, and between the partition wall part 245 and the first cover part 411. For example, the waterproof member 440 may be disposed on the surface 453a of the third portion 453 and a surface 245a of the partition wall part 245. The surface 245a of the partition wall part 245 may face the first cover part 411. The surface 245a of the partition wall part 245 may face in a direction (e.g., -z direction) in which the second surface 422 of the first electronic component 420 faces. The surface 245a of the partition wall part 245 may be substantially parallel to the first surface 421 of the first electronic component 420. The waterproof member 440 may be attached to the surface 453a of the third portion 453, the surface 245a of the partition wall part 245, and the first cover part 411. For example, when the partition wall part 245 extends along a direction (e.g., -y direction) toward the inside of the frame 240 in order to secure a space where the waterproof member 440 is attached, since a size of the audio path 246 through which audio from the first surface 421 of the first electronic component 420 may be outputted is reduced, the performance of the first electronic component 420 may be reduced. When the partition wall part 245 extends along a direction (e.g., +y direction) facing the outside of the frame 240 in order to secure a space where the waterproof member 440 is attached, since the overall size of the electronic device 200 increases, portability may be reduced. According to an embodiment, the electronic device 200 may provide a structure for securing a space to which the waterproof member 440 is attached without expanding the size of the electronic device 200, through the third portion 453 of the support plate 450 for reinforcing the rigidity of the first electronic component 420.

According to an embodiment, a first distance d1 between the first cover part 411 and the surface 245a of the partition wall part 245 may be smaller than a second distance d2 between the first cover part 411 and the second surface 422 of the first electronic component 420. For example, the first distance d1 may indicate a distance in a direction (e.g., -z direction) in which the second surface 422 of the first electronic component 420 faces. For example, the second distance d2 may indicate a distance in a direction (e.g., -z direction) in which the second surface 422 of the first electronic component 420 faces. A third distance d3 between the first cover part 411 and the surface 453a of the third portion 453 may be substantially the same as the first distance d1. For example, the first distance d1 and the third distance d3 may be substantially the same as the thickness of the waterproof member 440. The thickness of a component may indicate a distance in a direction (e.g., -z direction or +z direction) parallel to a direction (e.g., -z direction) in which the second surface 422 of the first electronic component 420 faces, and the expression may be used substantially the same below. According to an embodiment, the coupling member 260 may be disposed on the second surface 422 of the first electronic component 420. For example, the coupling member 260 may be attached to the second surface 422 of the first electronic component 420. The coupling member 260 may be spaced apart from the second cover part 412. The coupling member 260 may be spaced apart from the partition wall part 245. For example, when the cover plate 410 is viewed along a direction (e.g., +z direction) in which the first surface 421 of the first electronic component 420 faces, the coupling member 260 may not be overlapped with the partition wall part 245 and the second cover part. For example, when the cover plate 410 is viewed along a direction (e.g., +z direction) in which the first surface 421 of the first electronic component 420 faces, the coupling member 260 may be disposed outside the partition wall part 245 and the second cover part.

As described above, according to an embodiment, the electronic device 200 may provide a structure capable of securing a space in which the waterproof member 440 may be attached by the third portion 453 of the support plate 450 supporting the first electronic component 420.

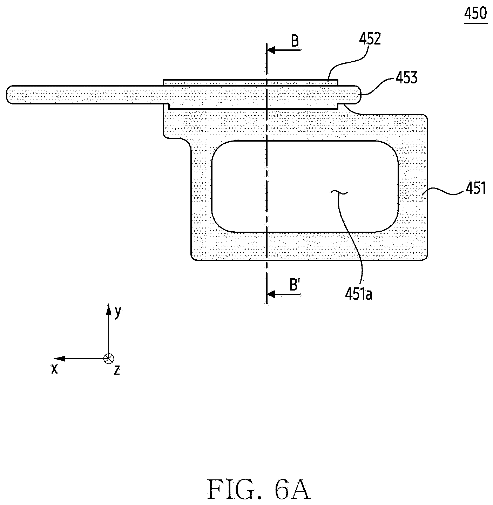

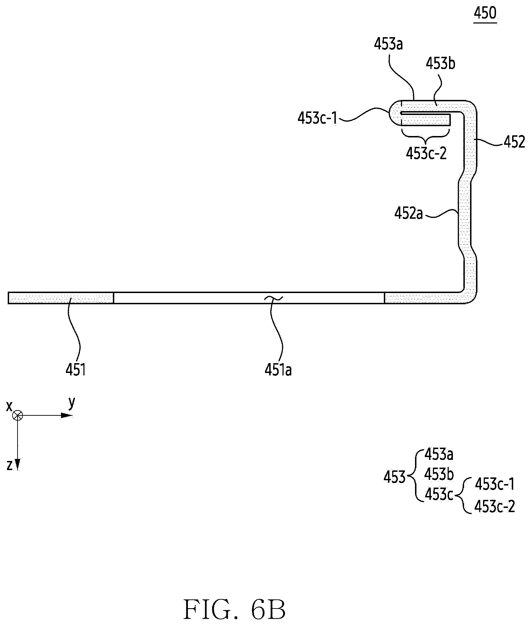

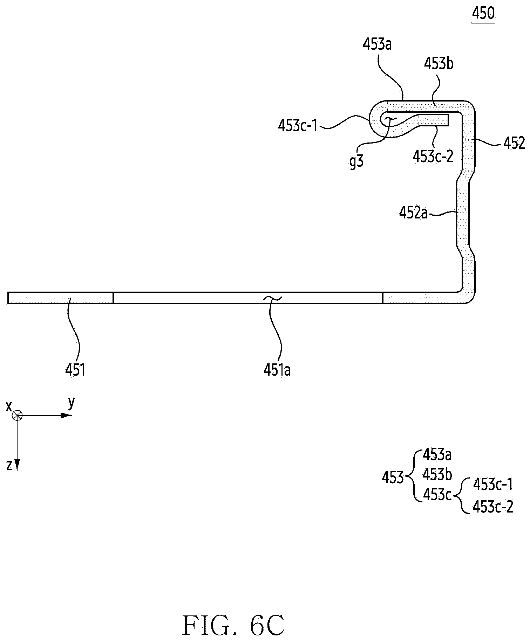

FIG. 6A is a top view of an exemplary support plate according to an embodiment, and FIG. 6B is a cross-sectional view illustrating an example of an exemplary support plate cut along line B-B' of FIG. 6A, according to an embodiment, and FIG. 6C is a cross-sectional view illustrating an example of an exemplary cut support plate according to an embodiment.

Referring to FIGS. 6A, 6B, and 6C, according to an embodiment, the first portion 451 may include a second opening 451a. The second opening 451a may provide (or form) a passage through which audio from a first surface (e.g., the first surface 421 of the first electronic component 420 of FIG. 4B) may move outside a frame (e.g., the frame 240 of FIG. 4A and FIG. 4B). The second opening 451a may penetrate the first portion 451. For example, a size of the second opening 451a may be smaller than a size of the first portion 451, but is not limited thereto.

According to an embodiment, the second portion 452 may include a protrusion 452a. The protrusion 452a may be formed to reinforce the rigidity of the second portion 452. The protrusion 452a may be formed by pressing the second portion 452. The protrusion 452a may be formed by pressing the second portion 452 in a direction (e.g., -y direction) in which the second portion 452 faces a first electronic component (e.g., the electronic component 420 of FIG. 4A and FIG. 4B). The protrusion 452a may be formed by a beading process.

According to an embodiment, the third portion 453 may include a first area 453b and a second area 453c.

According to an embodiment, the first area 453b may be connected to the second portion 452. The first area 453b may be substantially parallel to the first portion 451. According to an embodiment, the surface 453a of the third portion 453 may be disposed (or located) in the first area 453b. The surface 453a of the third portion 453 may be formed (or defined) in the first area 453b.

According to an embodiment, the second area 453c may be connected to the first area 453b. A portion 453c-1 of the second area 453c may be bent with respect to the first area 453b. For example, the portion 453c-1 of the second area 453c may be bent to have a curvature with respect to the first area 453b. Another portion 453c-2 of the second area 453c may be substantially parallel to the first area 453b. According to an embodiment, the other portion 453c-2 of the second area 453c substantially parallel to the first area 453b may be disposed under the first area 453b. For example, the other portion 453c-2 of the second area 453c may be overlapped with the first area 453b. At least a part of the second area 453c may be in contact with the first area 453b. For example, referring to FIG. 6B, the portion 453c-1 of the second area 453c and the other portion 453c-2 of the second area 453c may be in contact with the first area 453b. For example, referring to FIG. 6C, the portion 453c-1 of the second area 453c may be spaced apart from the first area 453b, and the other portion 453c-2 of the second area 453c may be in contact with the first area 453b. For example, a gap g3 may be positioned between the portion 453c-1 of the second area 453c and the first area 453b.

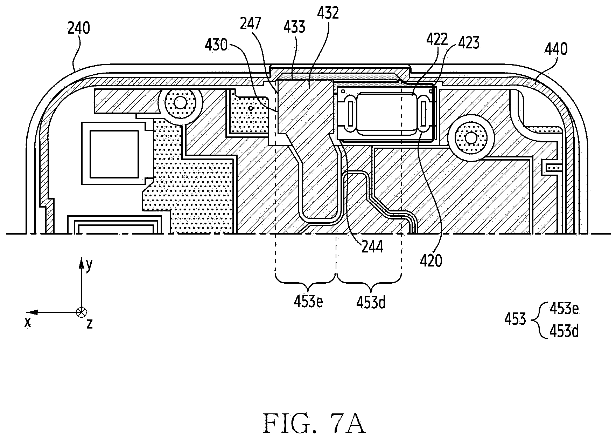

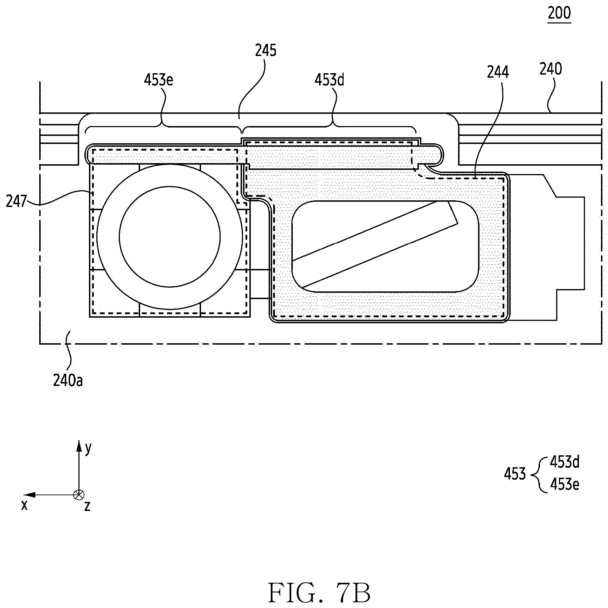

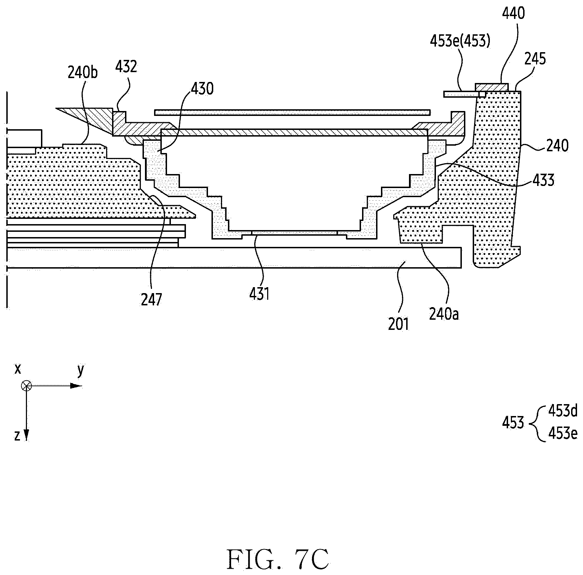

FIG. 7A is a rear view of an electronic device according to an embodiment, and FIG. 7B illustrates a state in which a support plate is coupled to an exemplary frame according to an embodiment, and FIG. 7C is a cross-sectional view illustrating an example of an exemplary electronic device cut along line C-C' of FIG. 7A, according to an embodiment.

FIG. 7A illustrates the electronic device 200 in a state in which the cover plate (e.g., the cover plate 410 of FIG. 4A and FIG. 4B) is removed.

Referring to FIGS. 7A and 7B, according to an embodiment, the frame 240 may include a recess part 247. The recess part 247 may be formed by recessing the surface 240a of the frame 240 inward. The recess part 247 may accommodate the second electronic component 430. The second electronic component 430 may be disposed within the recess part 247. The recess part 247 may be disposed adjacent to the seating part 244. For example, the recess part 247 may be spaced apart from the seating part 244 along a first direction (e.g., +x direction).

According to an embodiment, the second electronic component 430 may include a third surface 431, a fourth surface 432, and/or at least one other side surface 433. The third surface 431 may face in a direction (e.g., the +z direction) in which the first surface (e.g., the first surface 421 of the first electronic component 420 of FIG. 4B) faces. The third surface 431 may face in a direction (e.g., +z direction) in which the other surface 240b of the frame 240 faces. The third surface 431 may face the display 201. For example, the third surface 431 may be defined (or formed) by a lens (not shown) capable of transmitting light. When the third surface 431 is defined (or formed) by the lens, the second electronic component 430 may be configured to obtain an image based on receiving light through the lens. The fourth surface 432 may be opposite to the third surface 431. For example, a direction (e.g., -z direction) in which the fourth surface 432 faces may be opposite to a direction (e.g., +z direction) in which the third surface 431 faces. For example, the fourth surface 432 may be defined (or formed) by a printed circuit board of the second electronic component 430. At least one other side surface 433 may be disposed between the third surface 431 and the fourth surface 432. At least one other side surface 433 may connect the third surface 431 and the fourth surface 432. At least one other side surface 433 may extend from the third surface 431 to the fourth surface 432.

According to an embodiment, the partition wall part 245 may at least partially surround (or wrap) the recess part 247. The partition wall part 245 may extend along the side surface 423 of the first electronic component 420. For example, the partition wall part 245 may extend from the seating part 244 in a first direction (e.g., +x direction). The partition wall part 245 may face the first electronic component 420 and the second electronic component 430. For example, the partition wall part 245 may wrap (or surround) at least one side surface 423 of the first electronic component 420 and at least one other side surface 433 of the second electronic component 430.

According to an embodiment, the third portion 453 may extend along the side surface 423 of the first electronic component 420. For example, the third portion 453 may extend from the seating part 244 along a first direction (e.g., +x direction). The third portion 453 may include a first attachment area 453d and a second attachment area 453e. The first attachment area 453d may correspond to the first electronic component 420. For example, the first attachment area 453d may correspond to at least a part of at least one side surface 423 of the first electronic component 420. The first attachment area 453d may indicate an area of the third portion 453 extending along at least a part of at least one side surface 423 of the first electronic component 420. The second attachment area 453e may correspond to the second electronic component 430. For example, the second attachment area 453e may correspond to at least one other side surface 433 of the second electronic component 430. For example, the second attachment area 453e may indicate another area of the third portion 453 extending along at least one other side surface 433 of the second electronic component 430. The second attachment area 453e may face at least a part of the fourth surface 432. The second attachment area 453e may be disposed on the fourth surface 432 of the second electronic component 430. For example, the second attachment area 453e may be spaced apart from the fourth surface 432 in a direction (e.g., -z direction) in which the fourth surface 432 faces, but is not limited thereto. The first attachment area 453d and the second attachment area 453e may define (or form) a space in which the waterproof member 440 may be attached. The waterproof member 440 may be disposed on the first attachment area 453d and the second attachment area 453e of the third portion 453. For example, the waterproof member 440 may be contact (or attached) to the first attachment area 453d and the second attachment area 453e.

As described above, according to an embodiment, the electronic device 200 may provide a structure capable of securing a space to which the waterproof member 440 is attached without expanding the size of the electronic device 200, by the third portion 453 extending to correspond to at least one side surface 433 of the second electronic component 430.

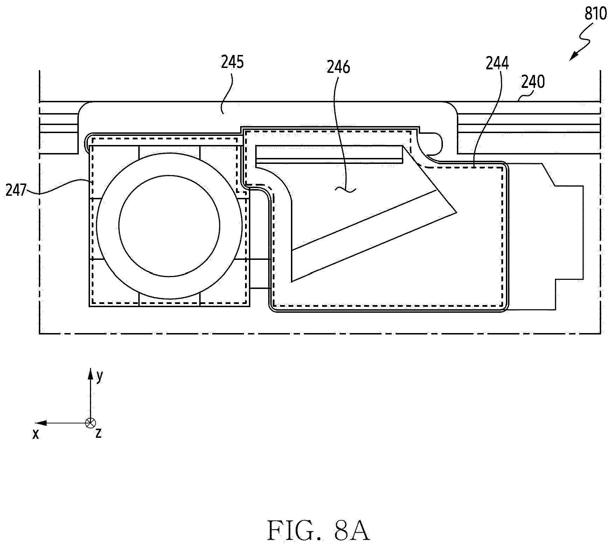

FIGS. 8A to 8E illustrate an example of a method of manufacturing an electronic device according to an embodiment.

Referring to FIG. 8A, in a state 810, the frame 240 may be provided. For example, the frame 240 may be formed using a molten resin. The frame 240 may be formed by an injection process. The seating part 244, the partition wall part 245, the audio path 246, and/or the recess part 247 may be defined (or formed) by a shape of a mold used in the injection process. However, it is not limited thereto. For example, the frame 240 may be formed by cutting a metal into a specified shape.

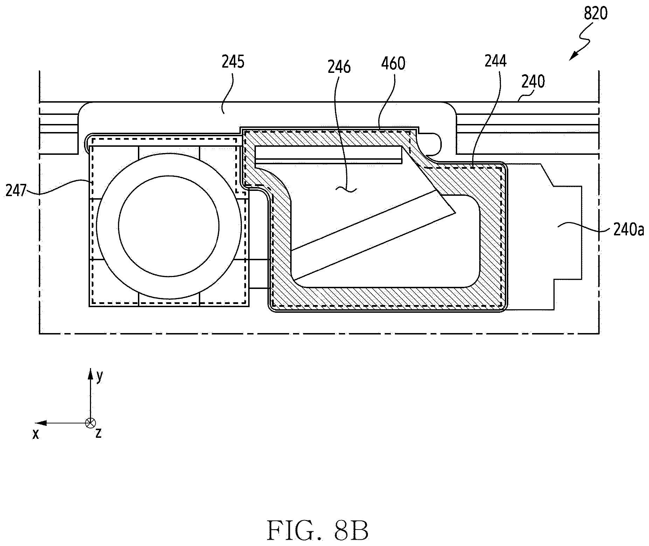

Referring to FIG. 8B, in a state 820, the adhesive member 460 may be disposed on the surface 240a of the frame 240. The adhesive member 460 may be disposed on the seating part 244. For example, the adhesive member 460 may surround (or wrap) the audio path 246.

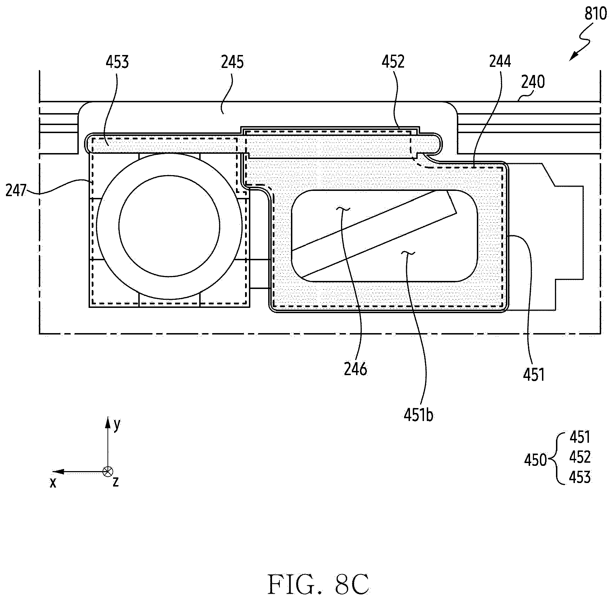

Referring to FIG. 8C, in a state 830, the support plate 450 may be disposed in the seating part 244. For example, the first portion 451 may be attached to the adhesive member 460. The second portion 452 may face the partition wall part 245. The third portion 453 may be disposed on the seating part 244 and the recess part 247. The second opening 451a may be disposed on the seating part 244 to be aligned with the audio path 246. At least a part of the second opening 451a may be overlapped with the audio path 246.

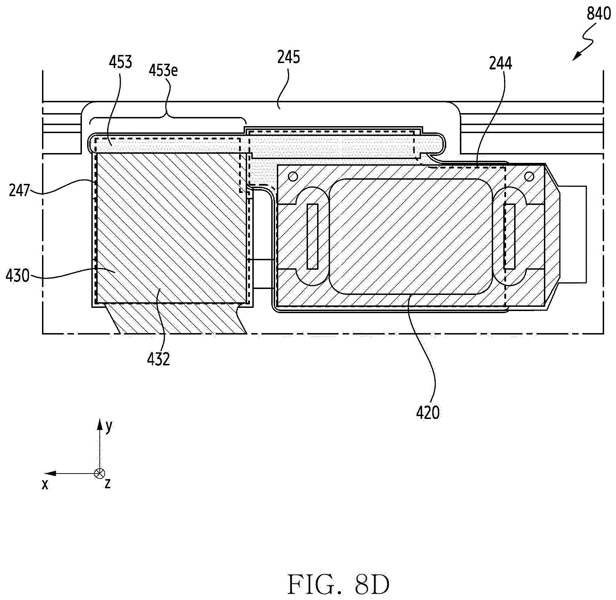

Referring to FIG. 8D, in a state 840, the first electronic component 420 may be disposed in the seating part 244. The first electronic component 420 may be disposed on the first portion 451. The first electronic component 420 may contacted (or attached) to the first portion 451 through the adhesive material. The second electronic component 430 may be disposed in the recess part 247. The fourth surface 432 of the second electronic component 430 may face the second attachment area 453e of the third portion 453. The first electronic component 420 and the second electronic component 430 may be at least partially surrounded (or wrapped) by the partition wall part 245.

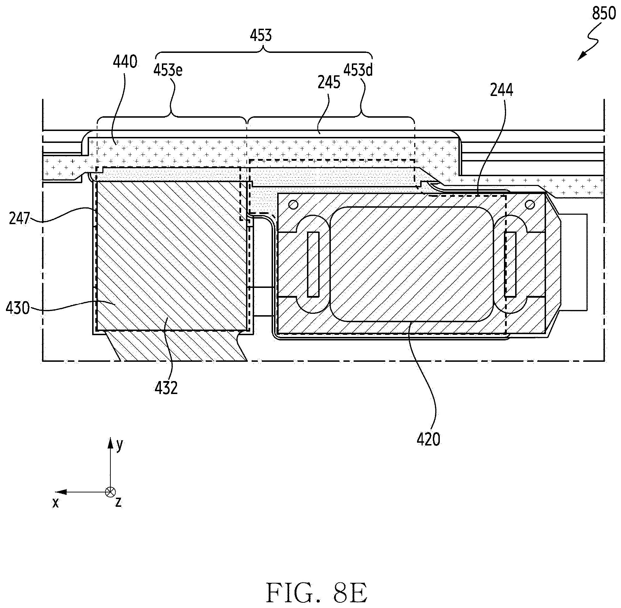

Referring to FIG. 8E, in a state 850, the waterproof member 440 may be disposed on the partition wall part 245 and the third portion 453. For example, the waterproof member 440 may be contacted (or attached) to the partition wall part 245, the first attachment area 453d, and the second attachment area 453e.

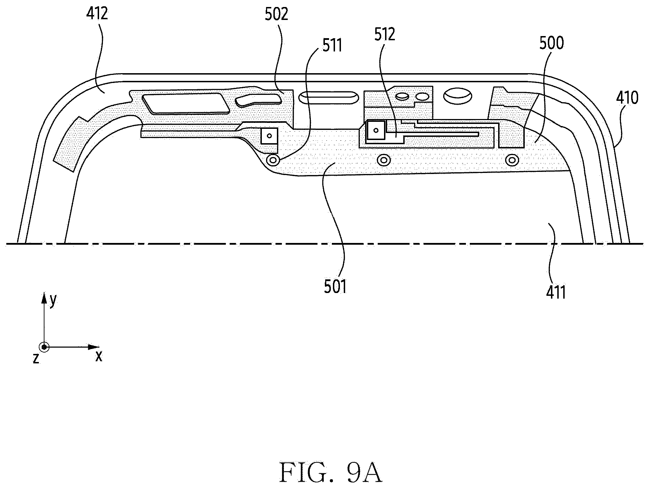

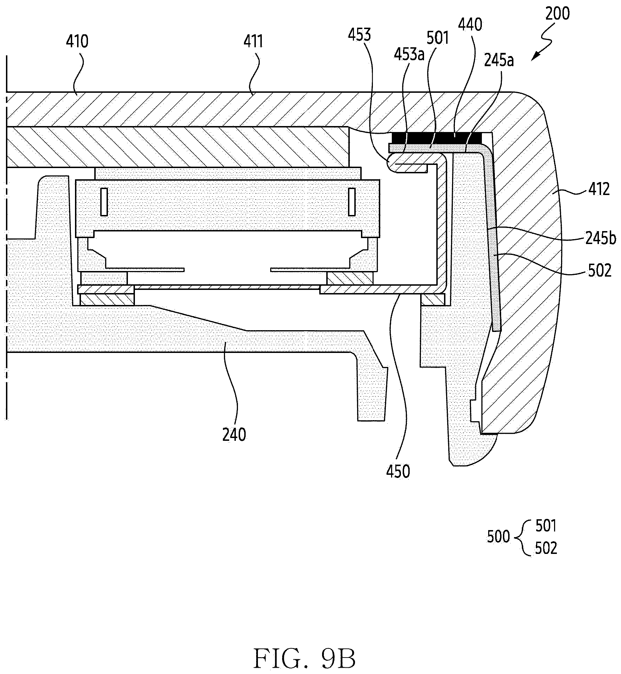

FIG. 9A illustrates an exemplary cover plate according to an embodiment, and FIG. 9B is a cross-sectional view illustrating an example of a cut electronic device according to an embodiment.

Referring to FIGS. 9A and 9B, according to an embodiment, the electronic device 200 may include an antenna module 500. The antenna module 500 may include one or more antenna radiators for communication with another electronic device outside the electronic device 200. The electronic device 200 may be configured to communicate based on transmitting or receiving a signal on a frequency in a designated band to another electronic device through the antenna module 500. According to an embodiment, the antenna module 500 may include a flexible printed circuit board 510 and an antenna radiator 520. The flexible printed circuit board 510 may have flexibility. The antenna radiator 520 may be formed on the flexible printed circuit board 510. The antenna radiator 520 may include a conductive material (e.g., metal). The antenna module 500 may be referred to as a flexible printed circuit board (FPCB) antenna.

According to an embodiment, the antenna module 500 may be disposed on the first cover part 411 and the second cover part 412. For example, a portion 501 of the antenna module 500 may be disposed along the first cover part 411. For example, another portion 502 of the antenna module 500 may be disposed along the second cover part 412. According to an embodiment, the antenna module 500 may be disposed between the frame 240 and the cover plate 410. For example, the portion 501 of the antenna module 500 may be disposed between the surface 245a of the partition wall part 245 and the first cover part 411. The portion 501 of the antenna module 500 may be disposed between the third portion 453 and the waterproof member 440. For example, the other portion 502 of the antenna module 500 may be disposed between the side surface 245b of the partition wall part 245 and the second cover part 412.

According to an embodiment, the antenna module 500 may be electrically connected to the third portion 453. The third portion 453 may provide an electrical ground to the antenna module 500. For example, the third portion 453 may be formed of a conductive material (e.g., metal). The third portion 453 may be electrically connected to a ground layer in the antenna module 500. For example, the ground layer of the antenna module 500 may be exposed to the outside of the antenna module 500, but is not limited thereto. For example, the antenna module 500 may be electrically connected to the third portion 453 providing the ground, as the portion 501 of the antenna module 500 is in contact with the third portion 453. Since the third portion 453 provides an electrical ground of the antenna module 500, the performance of the antenna module 500 may be improved. For example, the electrical ground provided by the third portion 453 may reduce noise interfering with an operation of the antenna module 500.

As described above, according to an embodiment, since the third portion 453 of the support plate 450 for attaching the waterproof member 440 provides the ground of the antenna module 500, the electronic device 200 may provide a structure capable of filling a gap between the frame 240 and the cover plate 410 and securing the performance of the antenna module 500.

In order to reduce damage to components in an electronic device due to the inflow of foreign substances, an electronic device may require a structure to seal the electronic device. By the structure for sealing the electronic device, a size of the electronic device may increase, or a space in which components in the electronic device may be disposed may decrease. The electronic device may require a sealing structure capable of saving a space in which components may be disposed without increasing the size of the electronic device.

An electronic device (e.g., the electronic device 200 of FIG. 4A and FIG. 4B) is provided. According to the invention, the electronic device comprises a first electronic component (e.g., the first electronic component 420 of FIG. 4B). According to the invention, the electronic device comprises a frame (e.g., the frame 240 of FIG. 5) accommodating the first electronic component and including a surface (e.g., the surface 240a of FIG. 5) to which the first electronic component is attached, and a partition wall part (e.g., the partition wall part 245 of FIG. 5) protruding from the surface. According to the invention, the electronic device comprises a cover plate (e.g., the cover plate 410 of FIG. 5) coupled to the frame, the cover plate including a first cover part (e.g., the first cover part 411 of FIG. 5), wherein the surface 240a of the frame 240 faces and is spaced apart from the first cover part 411 and wherein the first cover part 411 is disposed on the first electronic component 420 and the partition wall part (245) and the cover plate further includes a second cover part (e.g., the second cover part 412 of FIG. 5) being bent with respect to the first cover part and surrounding the partition wall part 245. According to the invention, the electronic device comprises a support plate (e.g., the support plate 450 of FIG. 5) including a first portion (e.g., the first portion 451 of FIG. 5) interposed between the first electronic component and the surface of the frame, a second portion (e.g., the second portion 452 of FIG. 5) extending toward the first cover part between the first electronic component and the partition wall part, and a third portion (e.g., the third portion 453 of FIG. 5) being bent with respect to the second portion. According to the invention, the electronic device comprises a waterproof member (e.g., the waterproof member 440 of FIG. 5) interposed between the third portion and the first cover part and between the partition wall part and the first cover part so as to fill a gap between the frame and the cover plate.

According to an embodiment, the electronic device may provide a structure capable of securing a space in which the waterproof member may be attached and miniaturizing the electronic device by the third portion of the support plate attached to the first electronic component.

According to an embodiment, a distance between the first cover part and a surface (e.g., the surface 245a of FIG. 5) of the partition wall part facing the first cover part may be smaller than a distance between the first cover part and the first electronic component. According to an embodiment, a distance between the first cover part and a surface (e.g., the surface 245a of FIG. 5) of the partition wall part facing the first cover part may be less than half a distance between the first cover part and the first electronic component.

According to an embodiment, since the distance between the first cover part and the surface of the partition wall part is smaller than the distance between the first cover part and the second surface, the electronic device may provide a structure in which a shape of a gap between the frame and the cover plate is relatively simplified. As the shape of the gap is simplified, costs for manufacturing a structure for sealing the electronic device may be saved.

According to an embodiment, the waterproof member may be in contact with the frame and the cover plate by extending along an edge of the cover plate. According to an embodiment, the waterproof member may be in contact with the frame and the cover plate by extending along a first direction x and along a second direction y, i.e. along an edge of the cover plate. According to an embodiment, the first direction x, the second direction y, and a third direction z are perpendicular to each other.

According to an embodiment, the electronic device may provide a structure capable of reducing the inflow of foreign substances into the electronic device by the waterproof member sealing the frame and the cover plate.

According to an embodiment, the third portion may be bent with respect to the second portion in a direction away from the partition wall part. According to an embodiment, the direction away from the partition wall part corresponds to a direction -y opposite to the second direction y.

According to an embodiment, since the third portion is bent in a direction away from the partition wall part, the electronic device may provide a structure capable of saving a space inside the electronic device compared to a case in which the third portion is bent toward a direction approaching the partition wall part.

According to an embodiment, the first portion may have a shape parallel to the surface of the frame. According to an embodiment, a surface of the third portion to which the waterproof member is attached may be parallel to the first portion.

According to an embodiment, the electronic device may comprise an adhesive member (e.g., the adhesive member 460 of FIG. 5) interposed between the surface of the frame and the first portion.

According to an embodiment, the electronic device may provide a structure in which the support plate may reinforce the rigidity of the first electronic component by an adhesive member that seats the first portion on the seating part (e.g., the seating part 244 of the frame 240 of FIG. 5).

According to an embodiment, the first electronic component may be configured to emit audio through a first surface (e.g., the first surface 421 of the first electronic component 420 of FIG. 4B) facing the surface of the frame.

According to an embodiment, the electronic device may be configured to provide audio to a user through the first electronic component.

According to an embodiment, the first portion may include an opening (e.g., the second opening 451a of FIG. 6A, FIG. 6B, and FIG. 6C) penetrating the first portion such that the audio from the first surface is transmitted to outside of the frame.

According to an embodiment, since the first portion attached to the first surface includes an opening, the electronic device may provide a structure in which audio from the first surface is transmitted to the outside of the electronic device.

According to an embodiment, the electronic device may include a display (e.g., the display 201 of FIG. 4B) and the frame may include another surface (e.g., the other surface 240b of FIG. 5) opposite to the surface of the frame and on which the display is disposed. According to an embodiment, the electronic device may include an audio path (e.g., the audio path 246 of FIG. 5) penetrating the another surface of the frame such that the audio from the first surface is emitted to outside of the electronic device through a gap between the display and the frame.

According to an embodiment, since the frame includes an audio path connected to the opening, the electronic device may provide a structure in which the audio from the first surface may be transmitted to the outside of the electronic device.

According to an embodiment, the third portion may include a first area (e.g., the first area 453b of FIG. 6B and FIG. 6C) parallel to the first portion. According to an embodiment, the third portion may include a second area (e.g., the second area 453c of FIG. 6B and FIG. 6C) connected to the first area and bent to have a curvature with respect to the first area. According to an embodiment, a gap may be located between the first area and the second area.

According to an embodiment, since the support plate may be formed (or manufactured) through pressure, the electronic device may provide a structure capable of easily securing an area to which the waterproof member is attached.

According to an embodiment, the partition wall part may be disposed between the first electronic component and the second cover part.

According to an embodiment, the electronic device may provide a structure capable of protecting components inside the electronic device through the cover plate to be coupled to the frame.

According to an embodiment, the electronic device may comprise a coupling member (e.g., the coupling member 260 of FIG. 5) supporting the first electronic component by being interposed between the first electronic component and the first cover part.

According to an embodiment, the electronic device may provide a structure capable of maintaining a position of the first electronic component in the frame by the coupling member supporting the first electronic component.

According to an embodiment, the electronic device may comprise a second electronic component including a third surface (e.g., the third surface 431 of FIG. 7C) and a fourth surface (e.g., a fourth surface 432 of FIG. 7C) facing the first cover part opposite to the third surface, being spaced apart from the first electronic component, and accommodated within the frame. According to an embodiment, the partition wall part may surround the first electronic component and the second electronic component. According to an embodiment, the third portion may face the fourth surface by extending along the partition wall part.

According to an embodiment, since the third portion extends from an area on the frame in which the first electronic component is located to correspond to the second electronic component, the electronic device may provide a structure capable of securing an area to which the waterproof member may be attached.

According to an embodiment, the second electronic component may include an image sensor configured to acquire an image based on receiving light from outside of the electronic device.

According to an embodiment, the electronic device may comprise an antenna module (e.g., the antenna module 500 of FIG. 9A and FIG. 9B) disposed between the cover plate and the partition wall part. According to an embodiment, a portion of the antenna module may be in contact with the waterproof member by being disposed on the surface of the partition wall part facing the third portion and the first cover part.

According to an embodiment, since the antenna module is electrically connected to the third portion providing a ground of the antenna module, the electronic device may provide a structure capable of sealing the electronic device and securing the performance of the antenna module.

An electronic device (e.g., the electronic device 200 of FIG. 4A and FIG. 4B) is provided. According to an embodiment, the electronic device may comprise a frame (e.g., the frame 240 of FIG. 5) including a seating part (e.g., the seating part 244 of FIG. 5) and a partition wall part (e.g., the partition wall part 245 of FIG. 5) protruding from the seating part. According to an embodiment, the electronic device may comprise a first electronic component (e.g., the first electronic component 420 of FIG. 4B) accommodated within the frame and including a first surface (e.g., the first surface 421 of the first electronic component 420 of FIG. 4B) facing the seating part, a second surface (e.g., the second surface 422 of the first electronic component 420 of FIG. 4B) opposite to the first surface, and a side surface (e.g., at least one side surface 423 of the first electronic component 420 of FIG. 4B) connecting the first surface and the second surface and facing the partition wall part. According to an embodiment, the electronic device may comprise a cover plate (e.g., the cover plate 410 of FIG. 5) including a first cover part (e.g., the first cover part 411 of FIG. 5) facing the second surface and a second cover part (e.g., the second cover part 412 of FIG. 5) connected to the first cover part and surrounding the partition wall part. According to an embodiment, the electronic device may comprise a support plate (e.g., the support plate 450 of FIG. 5) including a first portion (e.g., the first portion 451 of FIG. 5) interposed between the first surface and the seating part, a second portion (e.g., the second portion 452 of FIG. 5) extending towards the first cover part between the side surface and the partition wall part, and a third portion (e.g., the third portion 453 of FIG. 5) bent with respect to the second portion. According to an embodiment, the electronic device may comprise a waterproof member (e.g., the waterproof member 440 of FIG. 5) that fills a gap between the frame and the cover plate by contacting a portion of the waterproof member with the first cover part and a surface of the third portion facing the first cover part and contacting another portion of the waterproof member with first cover part and a surface of the partition wall part facing the first cover part.

According to an embodiment, the electronic device may provide a structure capable of securing a space in which a waterproof member may be attached and miniaturizing an electronic device, by the third portion of the support plate attached to the first electronic component.

According to an embodiment, a distance between the first cover part and a surface (e.g., the surface 245a of FIG. 5) of the partition wall part facing the first cover part may be smaller than a distance between the first cover part and the electronic component.

According to an embodiment, since a distance between the first cover part and the surface of the partition wall part is smaller than the distance between the first cover part and the second surface, the electronic device may provide a structure in which a shape of a gap between the frame and the cover plate is relatively simplified. As the shape of the gap is simplified, costs for manufacturing a structure for sealing the electronic device may be saved.

According to an embodiment, the waterproof member may be in contact with the frame and the cover plate by extending along an edge of the cover plate.

According to an embodiment, the electronic device may provide a structure capable of reducing the inflow of foreign substances into the electronic device by the waterproof member sealing the frame and the cover plate.

According to an embodiment, the third portion may be bent with respect to the second portion in a direction away from the partition wall part.

According to an embodiment, since the third portion is bent in a direction away from the partition wall part, the electronic device may provide a structure capable of saving a space inside the electronic device compared to a case in which the third portion is bent toward a direction approaching the partition wall part.

According to an embodiment, the first portion may have a shape parallel to a first surface of the electronic component facing the seating part. According to an embodiment, the surface of the third portion to which the waterproof member is attached may be parallel to the first surface of the electronic device.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which where data is semi-permanently stored in the storage medium and where a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200), comprising:
a first electronic component (420);
a frame (240) accommodating the first electronic component (420) and including a surface (240a) to which the first electronic component (420) is attached, and a partition wall part (245) protruding from the surface (240a);
a cover plate (410) coupled to the frame (240), the cover plate (410) including:
a first cover part (411), wherein the surface (240a) of the frame (240) faces and is spaced apart from the first cover part (411) and wherein the first cover part (411) is disposed on the first electronic component (420) and the partition wall part (245),
a second cover part (412) being bent with respect to the first cover part (411) and surrounding the partition wall part (245);
a support plate (450) including:
a first portion (451) interposed between the first electronic component (420) and the surface (240a) of the frame (240),
a second portion (452) extending toward the first cover part (411) between the first electronic component (420) and the partition wall part (245), and
a third portion (453) being bent with respect to the second portion (452); and
a waterproof member (440) interposed between the third portion (453) and the first cover part (411) and between the partition wall part (245) and the first cover part (411).

2. The electronic device (101; 200) of claim 1,
wherein a distance (d1) between the first cover part (411) and a surface (245a) of the partition wall part (245) facing the first cover part (411) is smaller than a distance (d2) between the first cover part (411) and the first electronic component (420).

3. The electronic device (101; 200) of any one of claims 1 and 2,
wherein the waterproof member (440) is in contact with the frame (240) and the cover plate (410) by extending along an edge of the cover plate (410).

4. The electronic device (101; 200) of any one of claims 1 to 3,
wherein the third portion (453) is bent with respect to the second portion (452) in a direction (-y) away from the partition wall part (245).

5. The electronic device (101; 200) of any one of claims 1 to 4,
wherein the first portion (451) has a shape parallel to the surface (240a) of the frame (240), and
wherein a surface (453a) of the third portion (453) to which the waterproof member (440) is attached is parallel to the first portion (451).

6. The electronic device (101; 200) of any one of claims 1 to 5, further comprising:
an adhesive member (460) interposed between the surface (240a) of the frame (240) and the first portion (451).

7. The electronic device (101; 200) of any one of claims 1 to 6,
wherein the first electronic component (420) is configured to emit audio through a first surface (421) facing the surface (240a) of the frame (240).

8. The electronic device (101; 200) of claim 7,
wherein the first portion (451) includes an opening (451a) penetrating the first portion (451) such that the audio from the first surface (241) is transmitted to outside of the frame (240).

9. The electronic device (101; 200) of claim 7,
wherein the electronic device (101; 200) further includes a display (201);
wherein the frame (240) includes another surface (240b) opposite to the surface (240a) of the frame (240) and on which the display (201) is disposed, and
wherein the electronic device (101; 200) comprises:
an audio path (246) penetrating the another surface (240b) of the frame (240) such that the audio from the first surface (241) is emitted to outside of the electronic device (101; 200) through a gap (g1) between the display (201) and the frame (240).

10. The electronic device (101; 200) of any one of claims 1 to 9,
wherein the third portion (453) includes:
a first area (453b) parallel to the first portion (451); and
a second area (453c) connected to the first area (453b) and bent to have a curvature with respect to the first area (453b), and
wherein a gap (g3) is located between the first area (453b) and the second area (453c).

11. The electronic device (101; 200) of any one of claims 1 to 10,
wherein the partition wall part (245) is disposed between the first electronic component (420) and the second cover part (412).

12. The electronic device (101; 200) of any one of claims 1 to 11, further comprising:
a coupling member (260) supporting the first electronic component (420) by being interposed between the first electronic component (420) and the first cover part (411).

13. The electronic device (101; 200) of any one of claims 1 to 12, further comprising:
a second electronic component (430) including a third surface (431) and a fourth surface (432) facing the first cover part (411) opposite to the third surface (431), being spaced apart from the first electronic component (420), and accommodated within the frame (240), and
wherein the partition wall part (245) extends to surround the first electronic component (420) and the second electronic component (430), and
wherein the third portion (453) faces the fourth surface (432) by extending along the partition wall part (245).

14. The electronic device (101; 200) of claim 13,
wherein the second electronic component (430) includes an image sensor configured to acquire an image based on receiving light from outside of the electronic device (101; 200).

15. The electronic device (101; 200) of any one of claims 1 to 14, further comprising:
an antenna module (500) disposed between the cover plate (410) and the partition wall part (245), and
wherein a portion of the antenna module (500) is in contact with the waterproof member (440) by being disposed on the surface (245a) of the partition wall part (245) facing the third portion (453) and the first cover part (411).

## Patentansprüche

1. Elektronisches Gerät (101; 200), umfassend:
eine erste elektronische Komponente (420);
einen Rahmen (240), der die erste elektronische Komponente (420) aufnimmt und eine Oberfläche (240a), an der die erste elektronische Komponente (420) angebracht ist, sowie ein Trennwandteil (245) umfasst, das von der Oberfläche (240a) vorsteht;
eine mit dem Rahmen (240) gekoppelte Abdeckplatte (410), wobei die Abdeckplatte (410) Folgendes umfasst:
ein erstes Abdeckteil (411), wobei die Oberfläche (240a) des Rahmens (240) dem ersten Abdeckteil (411) zugewandt und von diesem beabstandet ist, und wobei das erste Abdeckteil (411) auf der ersten elektronischen Komponente (420) und dem Trennwandteil (245) angeordnet ist,
ein zweites Abdeckteil (412), das in Bezug auf das erste Abdeckteil (411) gebogen ist und das Trennwandteil (245) umgibt;
eine Stützplatte (450) mit:
einem ersten Abschnitt (451), der zwischen der ersten elektronischen Komponente (420) und der Oberfläche (240a) des Rahmens (240) angeordnet ist,
einem zweiten Abschnitt (452), der sich zwischen der ersten elektronischen Komponente (420) und dem Trennwandteil (245) in Richtung des ersten Abdeckteils (411) erstreckt, und
einem dritten Abschnitt (453), der in Bezug auf den zweiten Abschnitt (452) gebogen ist; und
einem wasserdichten Element (440), das zwischen dem dritten Abschnitt (453) und dem ersten Abdeckteil (411) sowie zwischen dem Trennwandteil (245) und dem ersten Abdeckteil (411) angeordnet ist.

2. Elektronisches Gerät (101; 200) nach Anspruch 1,
wobei ein Abstand (d1) zwischen dem ersten Abdeckteil (411) und einer Oberfläche (245a) des Trennwandteils (245), die dem ersten Abdeckteil (411) zugewandt ist, kleiner ist als ein Abstand (d2) zwischen dem ersten Abdeckteil (411) und der ersten elektronischen Komponente (420).

3. Elektronisches Gerät (101; 200) nach einem der Ansprüche 1 und 2,
wobei das wasserdichte Element (440) mit dem Rahmen (240) und der Abdeckplatte (410) in Kontakt steht, indem es sich entlang einer Kante der Abdeckplatte (410) erstreckt.

4. Elektronisches Gerät (101; 200) nach einem der Ansprüche 1 bis 3,
wobei der dritte Abschnitt (453) in Bezug auf den zweiten Abschnitt (452) in einer Richtung (-y) weg von dem Trennwandteil (245) gebogen ist.

5. Elektronisches Gerät (101; 200) nach einem der Ansprüche 1 bis 4,
wobei der erste Abschnitt (451) eine Form aufweist, die parallel zur Oberfläche (240a) des Rahmens (240) ist, und
wobei eine Oberfläche (453a) des dritten Abschnitts (453), an der das wasserdichte Element (440) angebracht ist, parallel zum ersten Abschnitt (451) parallel ist.

6. Elektronisches Gerät (101; 200) nach einem der Ansprüche 1 bis 5, umfassend ferner:
ein Klebeelement (460), das zwischen der Oberfläche (240a) des Rahmens (240) und dem ersten Abschnitt (451) angeordnet ist.

7. Elektronisches Gerät (101; 200) nach einem der Ansprüche 1 bis 6,
wobei die erste elektronische Komponente (420) dazu konfiguriert ist, Ton über eine der Oberfläche (240a) des Rahmens (240) zugewandte erste Oberfläche (421) auszugeben.

8. Elektronisches Gerät (101; 200) nach Anspruch 7,
wobei der erste Abschnitt (451) eine Öffnung (451a) umfasst, die den ersten Abschnitt (451) durchdringt, so dass der Ton von der ersten Oberfläche (241) nach außen aus dem Rahmen (240) übertragen wird.

9. Elektronisches Gerät (101; 200) nach Anspruch 7,
wobei das elektronische Gerät (101; 200) ferner eine Anzeige (201) umfasst;
wobei der Rahmen (240) eine weitere Oberfläche (240b) umfasst, die der Oberfläche (240a) des Rahmens (240) gegenüberliegt und auf der die Anzeige (201) angeordnet ist, und
wobei das elektronische Gerät (101; 200) Folgendes umfasst:
einen Audiopfad (246), der die weitere Oberfläche (240b) des Rahmens (240) so durchdringt, dass der Ton von der ersten Oberfläche (241) durch einen Spalt (g1) zwischen der Anzeige (201) und dem Rahmen (240) nach außen aus dem elektronischen Gerät (101; 200) abgestrahlt wird.

10. Elektronisches Gerät (101; 200) nach einem der Ansprüche 1 bis 9,
wobei der dritte Abschnitt (453) Folgendes umfasst:
einen ersten Bereich (453b), der parallel zum ersten Abschnitt (451) verläuft; und
einen zweiten Bereich (453c), der mit dem ersten Bereich (453b) verbunden und so gebogen ist, dass er eine Krümmung in Bezug auf den ersten Bereich (453b) aufweist, und
wobei sich zwischen dem ersten Bereich (453b) und dem zweiten Bereich (453c) ein Spalt (g3) befindet.

11. Elektronisches Gerät (101; 200) nach einem der Ansprüche 1 bis 10,
wobei das Trennwandteil (245) zwischen der ersten elektronischen Komponente (420) und dem zweiten Abdeckteil (412) angeordnet ist.

12. Elektronisches Gerät (101; 200) nach einem der Ansprüche 1 bis 11, umfassend ferner:
ein Kopplungselement (260), das die erste elektronische Komponente (420) stützt, indem es zwischen der ersten elektronischen Komponente (420) und dem ersten Abdeckteil (411) angeordnet ist.

13. Elektronisches Gerät (101; 200) nach einem der Ansprüche 1 bis 12, umfassend ferner:
eine zweite elektronische Komponente (430) mit einer dritten Oberfläche (431) und einer vierten Oberfläche (432), die dem ersten Abdeckteil (411) gegenüber der dritten Oberfläche (431) zugewandt ist, die von der ersten elektronischen Komponente (420) beabstandet und innerhalb des Rahmens (240) untergebracht ist, und
wobei sich das Trennwandteil (245) so erstreckt, dass es die erste elektronische Komponente (420) und die zweite elektronische Komponente (430) umgibt, und
wobei der dritte Abschnitt (453) der vierten Fläche (432) zugewandt ist, indem er sich entlang des Trennwandteils (245) erstreckt.

14. Elektronisches Gerät (101; 200) nach Anspruch 13,
wobei die zweite elektronische Komponente (430) einen Bildsensor umfasst, der dazu konfiguriert ist, ein Bild auf der Grundlage des Empfangs von Licht von außerhalb des elektronischen Geräts (101; 200) zu erfassen.

15. Elektronisches Gerät (101; 200) nach einem der Ansprüche 1 bis 14, umfassend ferner:
ein Antennenmodul (500), das zwischen der Abdeckplatte (410) und dem Trennwandteil (245) angeordnet ist, und
wobei ein Abschnitt des Antennenmoduls (500) mit dem wasserdichten Element (440) in Kontakt steht, indem er auf der Oberfläche (245a) des Trennwandteils (245) angeordnet ist, die dem dritten Abschnitt (453) und dem ersten Abdeckteil (411) zugewandt ist.

## Revendications

1. Équipement électronique (101 ; 200), comprenant :
un premier composant électronique (420) ;
un cadre (240) accueillant le premier composant électronique (420) et comportant une surface (240a) à laquelle est attaché le premier composant électronique (420), ainsi qu'une partie de cloison (245) faisant saillie à partir de la surface (240a) ;
une plaque de couverture (410) couplée au cadre (240), la plaque de couverture (410) comportant :
une première partie de couverture (411), dans laquelle la surface (240a) du cadre (240) fait face à la première partie de couverture (411) et en est espacée, et dans laquelle la première partie de couverture (411) est disposée sur le premier composant électronique (420) et sur la partie de cloison (245),
une deuxième partie de couverture (412) courbée par rapport à la première partie de couverture (411) et entourant la partie de cloison (245) ;
une plaque de support (450) comportant :
une première partie (451) interposée entre le premier composant électronique (420) et la surface (240a) du cadre (240),
une deuxième partie (452) s'étendant vers la première partie de couverture (411) entre le premier composant électronique (420) et la partie de cloison (245), et
une troisième partie (453) courbée par rapport à la deuxième partie (452) ; et
un élément étanche (440) interposé entre la troisième partie (453) et la première partie de couverture (411) et entre la partie de cloison (245) et la première partie de couverture (411).

2. Équipement électronique (101 ; 200) selon la revendication 1,
dans lequel une distance (d1) entre la première partie de couverture (411) et une surface (245a) de la partie de cloison (245) faisant face à la première partie de couverture (411) est inférieure à une distance (d2) entre la première partie de couverture (411) et le premier composant électronique (420).

3. Équipement électronique (101 ; 200) selon l'une quelconque des revendications 1 à 2,
dans lequel l'élément étanche (440) est en contact avec le cadre (240) et la plaque de couverture (410) en s'étendant le long d'un bord de la plaque de couverture (410).

4. Équipement électronique (101 ; 200) selon l'une quelconque des revendications 1 à 3,
dans lequel la troisième partie (453) est courbée par rapport à la deuxième partie (452) dans une direction (-y) éloignée de la partie de cloison (245).

5. Équipement électronique (101 ; 200) selon l'une quelconque des revendications 1 à 4,
dans lequel la première partie (451) présente une forme parallèle à la surface (240a) du cadre (240), et
dans lequel une surface (453a) de la troisième partie (453) à laquelle est attaché l'élément étanche (440) est parallèle à la première partie (451).

6. Équipement électronique (101 ; 200) selon l'une quelconque des revendications 1 à 5, comprenant en outre :
un élément adhésif (460) interposée entre la surface (240a) du cadre (240) et la première partie (451).

7. Équipement électronique (101 ; 200) selon l'une quelconque des revendications 1 à 6,
dans lequel le premier composant électronique (420) est configuré pour émettre un audio à travers une première surface (421) faisant face à la surface (240a) du cadre (240).

8. Équipement électronique (101 ; 200) selon la revendication 7,
dans lequel la première partie (451) comporte une ouverture (451a) pénétrant à travers la première partie (451) de sorte que l'audio provenant de la première surface (241) soit transmis vers l'extérieur du cadre (240).

9. Équipement électronique (101 ; 200) selon la revendication 7,
dans lequel l'équipement électronique (101 ; 200) comprend en outre un afficheur (201) ;
dans lequel le cadre (240) comporte une autre surface (240b) à l'opposé de la surface (240a) du cadre (240) et sur laquelle est disposé l'afficheur (201), et
dans lequel l'équipement électronique (101 ; 200) comprend :
un chemin audio (246) pénétrant à travers l'autre surface (240b) du cadre (240) de sorte que l'audio provenant de la première surface (241) soit émis vers l'extérieur du dispositif électronique (101 ; 200) à travers un espace (g1) entre l'afficheur (201) et le cadre (240).

10. Équipement électronique (101 ; 200) selon l'une quelconque des revendications 1 à 9,
dans lequel la troisième partie (453) comporte :
une première zone (453b) parallèle à la première partie (451) ; et
une deuxième zone (453c) reliée à la première zone (453b) et courbée pour présenter une courbure par rapport à la première zone (453b), et
dans lequel un espace (g3) est situé entre la première zone (453b) et la deuxième zone (453c).

11. Équipement électronique (101 ; 200) selon l'une quelconque des revendications 1 à 10,
dans lequel la partie de cloison (245) est disposée entre le premier composant électronique (420) et la deuxième partie de couverture (412).

12. Équipement électronique (101 ; 200) selon l'une quelconque des revendications 1 à 11, comprenant en outre :
un élément de couplage (260) soutenant le premier composant électronique (420) en étant interposé entre le premier composant électronique (420) et la première partie de couverture (411).

13. Équipement électronique (101 ; 200) selon l'une quelconque des revendications 1 à 12, comprenant en outre :
un deuxième composant électronique (430) comportant une troisième surface (431) et une quatrième surface (432) faisant face à la première partie de couverture (411) à l'opposé de la troisième surface (431), étant espacée du premier composant électronique (420), et logée à l'intérieur du cadre (240), et
dans lequel la partie de cloison (245) s'étend pour entourer le premier composant électronique (420) et le deuxième composant électronique (430), et
dans lequel la troisième partie (453) fait face à la quatrième surface (432) en s'étendant le long de la partie de cloison (245).

14. Équipement électronique (101 ; 200) selon la revendication 13,
dans lequel le deuxième composant électronique (430) comporte un capteur d'image configuré pour acquérir une image en recevant la lumière provenant de l'extérieur de l'équipement électronique (101 ; 200).

15. Équipement électronique (101 ; 200) selon l'une quelconque des revendications 1 à 14, comprenant en outre :
un module d'antenne (500) disposé entre la plaque de couverture (410) et la partie de cloison (245), et
dans lequel une partie du module d'antenne (500) est en contact avec l'élément étanche (440) en étant disposée sur la surface (245a) de la partie de cloison (245) faisant face à la troisième partie (453) et à la première partie de couverture (411).
